# EUROPEAN PATENT APPLICATION

(11) **EP 4 852 321 A1**
(43) Date of publication of application: **09.12.2026**
(21) Application number: 26181242.4
(22) Date of filing: 27.05.2026
(51) Int. Cl.: H03K 5/135

(54) **SYSTEM AND METHOD FOR SKEW CALIBRATION**

(30) Priority: 05.06.2025 US 202563818494 P; 23.10.2025 US 202519367815
(71) Applicant: SAMSUNG ELECTRONICS CO., LTD., Yeongtong-gu Suwon-si, Gyeonggi-do 16677 (KR)
(72) Inventor: KANG, Hyunwook, 95134 San Jose, CA (US); PARK, Joon Young, 95134 San Jose, CA (US); AHN, Hyun-A, 95134 San Jose, CA (US)
(74) Representative: Kuhnen & Wacker Patent- und Rechtsanwaltsbüro PartG mbB

(57) **Abstract**

A system and method for skew calibration. In some embodiments, a system includes: a first circuit (265, 255), configured, in a first state, to apply a first adjustment to a phase of a first clock signal (CLKIN) to generate a phase-adjusted clock signal (I, Q) having an adjusted phase; and a second circuit (230), configured to compare the phase of the phase-adjusted clock signal to a phase of a reference signal (Reference clock).

## Description

### FIELD

One or more aspects of embodiments according to the present disclosure relate to circuits with clock signals, and more particularly to a system and method for skew calibration.

### BACKGROUND

Clock signals may be used in various circuits, for example in serial communication links and for triggering sampling in analog to digital converters.

It is with respect to this general technical environment that aspects of the present disclosure are related.

The above information disclosed in this Background section is only for enhancement of understanding of the background and therefore the information discussed in this Background section does not necessarily constitute prior art.

### SUMMARY

According to an embodiment of the present disclosure, there is provided a system, including: a first circuit, configured, in a first state, to apply a first adjustment to a phase of a first clock signal to generate a phase-adjusted clock signal having an adjusted phase; and a second circuit, configured to compare the phase of the phase-adjusted clock signal to a phase of a reference signal.

In some embodiments, the first adjustment is a time-varying adjustment.

In some embodiments: the first clock signal is derived from a received clock signal, and the reference signal is derived from the received clock signal.

In some embodiments, the first circuit includes a pseudo-random number generator, and the first circuit is configured to apply the first adjustment to the phase of the first clock signal based on an output of the pseudo-random number generator.

In some embodiments, the first circuit is configured, in the first state, to adjust the phase by more than 1% of a period of the first clock signal and by less than 30% of the period of the first clock signal.

In some embodiments: the second circuit is configured to compare, at an edge of the phase-adjusted clock signal, the reference signal to a reference voltage.

In some embodiments, the second circuit includes a clocked comparator clocked by the phase-adjusted clock signal.

In some embodiments, a first input of the clocked comparator is connected to the reference signal, and a second input of the clocked comparator is connected to the reference voltage.

In some embodiments, the system further includes a digital low-pass filter, connected to an output of the clocked comparator.

In some embodiments, the digital low-pass filter includes an up-down counter.

In some embodiments, the system further includes a circuit for generating the reference signal.

In some embodiments, the reference signal has, at a point at which it equals a reference voltage, a slope less than 10 times a peak-to-peak amplitude of the reference signal divided by a period of the reference signal.

In some embodiments, the circuit for generating the reference signal includes a frequency-reducing circuit configured to generate, from a received clock signal, a reduced-frequency clock signal.

In some embodiments, the circuit for generating the reference signal further includes a low-pass filter.

In some embodiments, the first circuit is configured, in a second state, to apply a second adjustment to the phase of the first clock signal, the second adjustment being a fixed adjustment.

In some embodiments, the system further includes a digitally controlled delay line configured to apply the second adjustment.

According to an embodiment of the present disclosure, there is provided a method, including: applying a first adjustment to a phase of a first clock signal to generate a phase-adjusted clock signal having an adjusted phase; and comparing the phase of the phase-adjusted clock signal to a phase of a reference signal.

In some embodiments, the method further includes: determining that the phase of the phase-adjusted clock signal leads the phase of the reference signal; and in response to determining that the phase of the phase-adjusted clock signal leads the phase of the reference signal, adjusting a value of a counter.

According to an embodiment of the present disclosure, there is provided a system, including: means for applying a first adjustment to a phase of a first clock signal to generate a phase-adjusted clock signal having an adjusted phase; and a circuit, configured to compare the phase of the phase-adjusted clock signal to a phase of a reference signal.

In some embodiments, the first adjustment is a time-varying adjustment.

### BRIEF DESCRIPTION OF THE DRAWINGS

These and other features and advantages of the present disclosure will be appreciated and understood with reference to the specification, claims, and appended drawings wherein:
FIG. 1A is a system level diagram of a computing system, according to an embodiment of the present disclosure;
FIG. 1B is a waveform diagram, according to an embodiment of the present disclosure;
FIG. 1C is a system level diagram of an analog to digital converter system, according to an embodiment of the present disclosure;
FIG. 1D is a waveform diagram, according to an embodiment of the present disclosure;
FIG. 2A is a block diagram of a portion of a serial data receiver, according to an embodiment of the present disclosure;
FIG. 2B is a waveform diagram, according to an embodiment of the present disclosure;
FIG. 2C is a waveform diagram, according to an embodiment of the present disclosure;
FIG. 2D is a waveform diagram, according to an embodiment of the present disclosure;
FIG. 2E is a block diagram of a portion of a serial data receiver, according to an embodiment of the present disclosure;
FIG. 3A is a block diagram of a clock input circuit, according to an embodiment of the present disclosure;
FIG. 3B is a block diagram of a clock input circuit, according to an embodiment of the present disclosure;
FIG. 4A is a waveform diagram, according to an embodiment of the present disclosure;
FIG. 4B is a waveform diagram, according to an embodiment of the present disclosure;
FIG. 4C is a schematic diagram of a modified up-down counter circuit, according to an embodiment of the present disclosure;
FIG. 5A is a block diagram of a portion of a serial data receiver, according to an embodiment of the present disclosure;
FIG. 5B is a schematic diagram of a decimator, according to an embodiment of the present disclosure;
FIG. 5C is a waveform diagram, according to an embodiment of the present disclosure;
FIG. 6 is a block diagram of a portion of a serial data receiver, according to an embodiment of the present disclosure;
FIG. 7A is a flowchart of a method, according to an embodiment of the present disclosure;
FIG. 7B is a flowchart of a method, according to an embodiment of the present disclosure; and
FIG. 7C is a flowchart of a method, according to an embodiment of the present disclosure.

### DETAILED DESCRIPTION

The detailed description set forth below in connection with the appended drawings is intended as a description of exemplary embodiments of a system and method for skew calibration provided in accordance with the present disclosure and is not intended to represent the only forms in which the present disclosure may be constructed or utilized. The description sets forth the features of the present disclosure in connection with the illustrated embodiments. It is to be understood, however, that the same or equivalent functions and structures may be accomplished by different embodiments that are also intended to be encompassed within the scope of the disclosure. As denoted elsewhere herein, like element numbers are intended to indicate like elements or features.

Clock signals are used for various purposes in digital circuits. In some circumstances, a single clock signal may be used, e.g., a single-frequency signal approximating a square wave, carried on a single conductor (with respect to ground). Such a clock signal may be referred to as a "simple" clock signal, because it includes only one clock signal. In some circumstances a clock signal (which may be referred to herein as a "composite clock signal"), with multiple component clock signals carried on separate respective conductors, may be used, as discussed in further detail below.

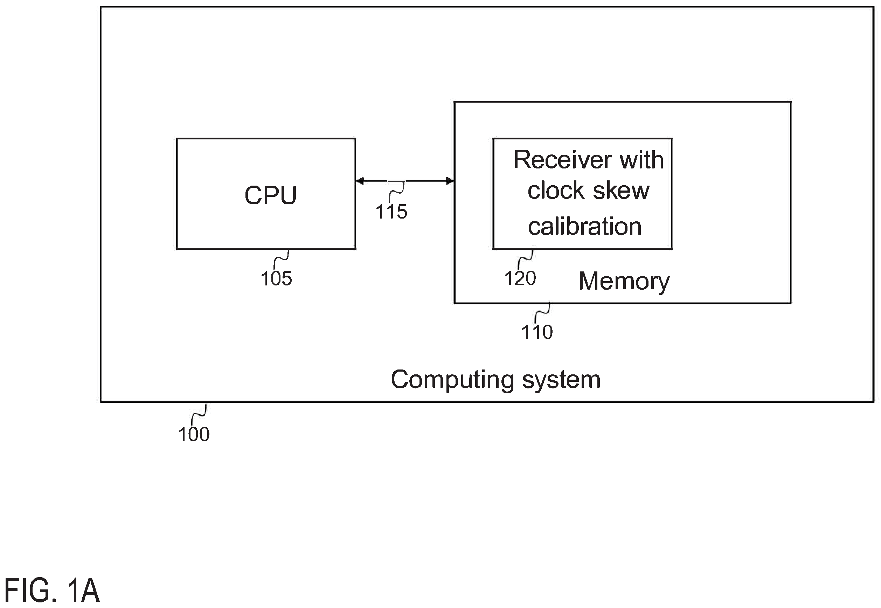

FIG. 1A depicts a simplified diagram of a computing system 100, in some embodiments. A central processing unit (CPU) 105 is connected to a memory 110 through a serial connection 115. The serial connection 115 may carry a clock signal to the memory along with one or more data signals. The memory 110 may include a receiver with clock skew calibration 120. The receiver with clock skew calibration 120 may, as part of a process of receiving and deserializing the received data, generate a composite clock signal, which may then be used to trigger comparisons in clocked comparators used to receive the data.

The composite clock signal generated by the receiver with clock skew calibration 120 may be a four-phase clock signal, including four clock signals at the same clock frequency and separated in phase. The four clock signals may include an in-phase signal (I), a quadrature signal (Q), a complement of the in-phase signal (IB), and a complement of the quadrature signal (QB). The four signals of the four-phase clock signal may nominally be separated by 90 degrees, e.g., the quadrature signal may lag the in-phase signal by 90 degrees, the complement of the in-phase signal may lag the quadrature signal by 90 degrees, and the complement of the quadrature signal may lag the complement of the in-phase by 90 degrees.

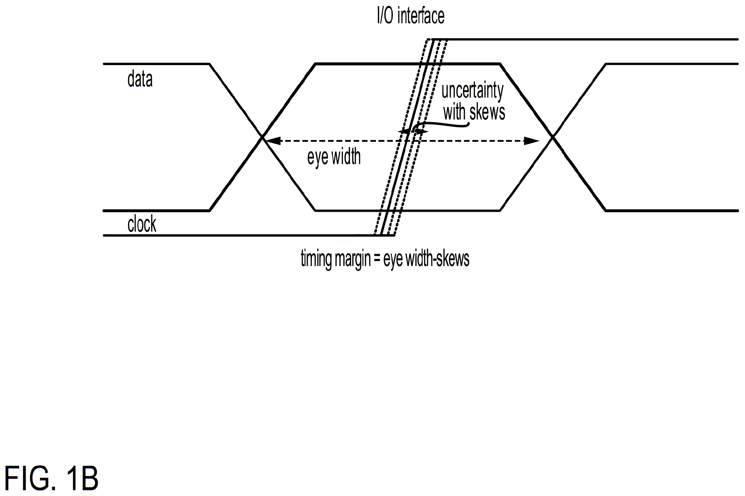

Deviations from the nominal 90 degrees of phase lag between adjacent signals of the composite four-phase clock signal may be referred to as "clock skew". Clock skew, if not corrected, may degrade the performance of the serial connection 115, for example by causing a clocked comparator to be triggered to early or too late, which may increase the likelihood that noise or uncompensated inter-symbol interference may cause a bit error. This is illustrated in FIG. 1B, which shows a schematic drawing of an eye diagram and, superimposed on the eye diagram, a clock signal, drawn several times with different respective amounts of clock timing error (e.g., clock skew). It may be seen from FIG. 1B that the timing margin (which depends on the eye width) is reduced in the presence of clock skew, with the timing margin being equal, in some embodiments, to the eye width minus the clock skew.

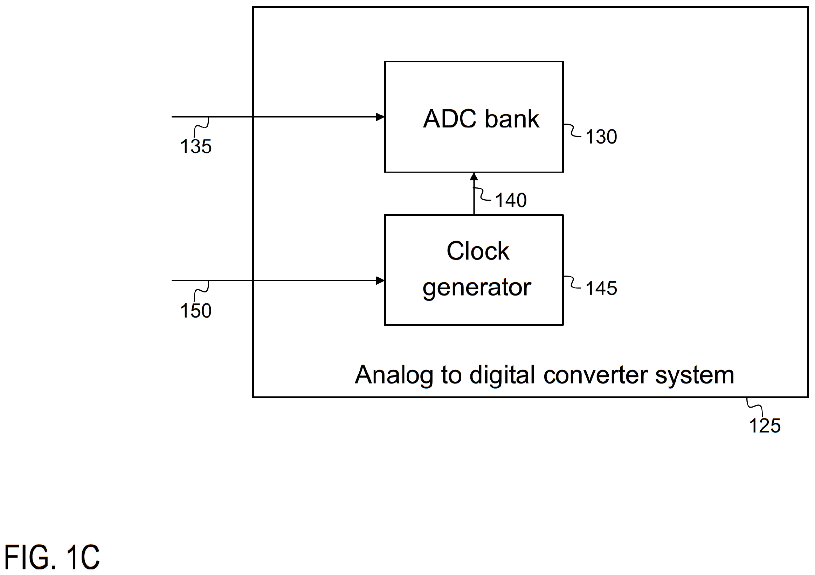

FIG. 1C depicts a simplified diagram of a high speed analog to digital converter system 125. In such a system, a bank of analog to digital converters 130 may each sample the same analog input signal 135, at different times, so that the total sample rate of the high speed analog to digital converter system may be N times the sample rate of any one of the analog to digital converters, where N is the number of analog to digital converters in the high speed analog to digital converter system. The time at which each of the analog to digital converters samples the analog input signal 135 may be determined by a clock signal it receives. Each of the analog to digital converters may receive a respective clock signal of a composite clock signal 140 including N clock signals, each with a different phase. For example, for N equal 32, the phase difference between adjacent clock signals within the composite clock signal may be 11.25 degrees.

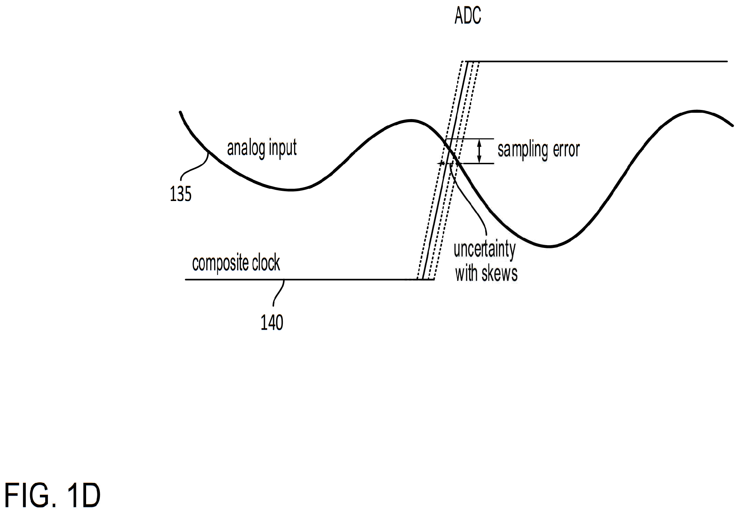

The composite clock signal of the high speed analog to digital converter system 125 may be generated by a clock generator 145, based on a received clock signal 150. Deviations from the nominal phase lag (e.g., 11.25 degrees, for N equal 32) between adjacent signals of the composite four-phase clock signal may degrade the performance of the high speed analog to digital converter system 125. For example, timing error (e.g., clock skew) in one of the clock signals of the composite clock signal may cause the corresponding analog to digital converter to be triggered to early or too late, which may result in a sampling error. This is illustrated in FIG. 1D, which shows a schematic drawing of an analog signal and, superimposed on the analog signal, a clock signal, drawn several times with different respective amounts of clock timing error (e.g., clock skew). It may be seen from FIG. 1D that the sampling error is increased in the presence of clock skew, with the sampling error being approximately equal to the product of (i) the rate of change of the analog signal and (ii) the timing error.

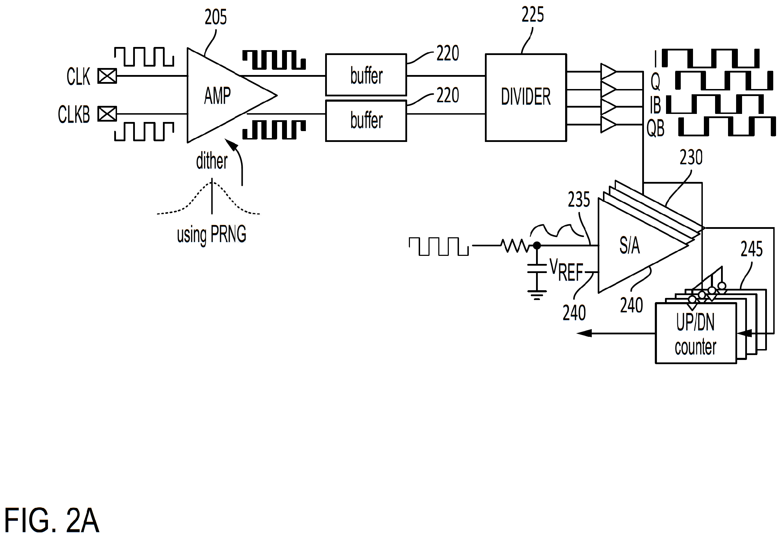

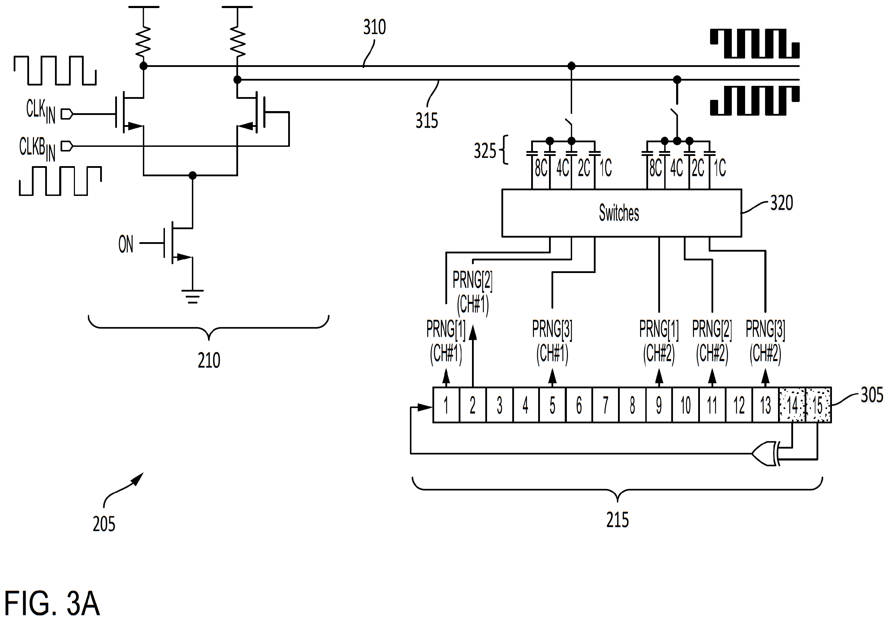

FIG. 2A shows the circuit of a portion of a serial data receiver, in some embodiments. The circuit may operate, at any time, in either of two states, a skew-calibration state and an operating state. The operation of the circuit in the skew-calibration state is illustrated in FIG. 2A. A clock signal and its complement are received at two inputs CLK (or DQS) and CLKB (or DQSB). The two clock signals are received by a clock input circuit 205 which includes a differential amplifier 210 (FIG. 3A), and which may include a phase dithering circuit 215 (FIG. 3A). The output of the clock input circuit 205 may be a phase-adjusted clock signal, which may be an amplified copy of the received complementary clock signal, with the phase being dithered. The phase dither may be a time-varying adjustment of the phase, applied by the phase dithering circuit 215. The amplitude of the dither may be significantly less than one cycle (e.g., significantly less than 360 degrees of phase). For example, the dither may adjust the phase by more than 1% of a period of the received clock signal and by less than 30% of the period of the received clock signal. Each of the signals of the complementary clock signal may be buffered by a respective buffer 220 (each of which may include, e.g., source followers, and may generate a higher-current copy of the signal it receives). The buffer may have an amplification factor (e.g., gain greater than 1) (i) to better compensate for any portion of the signal loss in the channel between the CPU 105 and the memory 110 that may have not been compensated for by the amplifier of the clock input circuit 205 or (ii) to provide additional drive current for driving any long routing paths, to extend the bandwidth.

The outputs of the buffers 220 may be fed to a divider circuit 225 which may generate the four signals of the four-phase composite clock signal, e.g., the in-phase signal (I), the quadrature signal (Q), the complement of the in-phase signal (IB) and the complement of the quadrature signal (QB). The divider circuit may accomplish this by, e.g., using flip flops to generate each of the four clock signals to have an edge on (i) each rising edge of the signal at the input to the divider circuit 225 or (ii) each falling edge of the signal at the input to the divider circuit 225, with the clock signals that are complements being initialized to have the opposite phase as the signals of which they are complements. For example, each of the in-phase signal and the complement of the in-phase signal may have a transition at each rising edge of the signal at the input to the divider circuit 225, and these two clock signals may be initialized so that they are out of phase with each other. Similarly, each of the quadrature signal and the complement of the quadrature signal may have a transition at each falling edge of the signal at the input to the divider circuit 225, and these two clock signals may also be initialized so that they are out of phase with each other.

Because the signal at the input to the divider circuit 225 has a time varying phase adjustment, the four signals of the four-phase composite clock signal may also be phase-adjusted clock signals, e.g., they may be dithered, e.g., each of these four signals may have a time-varying delay (e.g., a delay that varies in a pseudorandom manner, as discussed in further detail below). Each of the four clock signals of the four-phase composite clock signal may be fed to the clock input of a respective clocked comparator 230 (or "sense amplifier" (S/A)). The other two inputs of each clocked comparator 230 (which may be referred to as the "comparator input" and the "reference input") are connected to a reference signal 235 and a reference voltage 240, respectively.

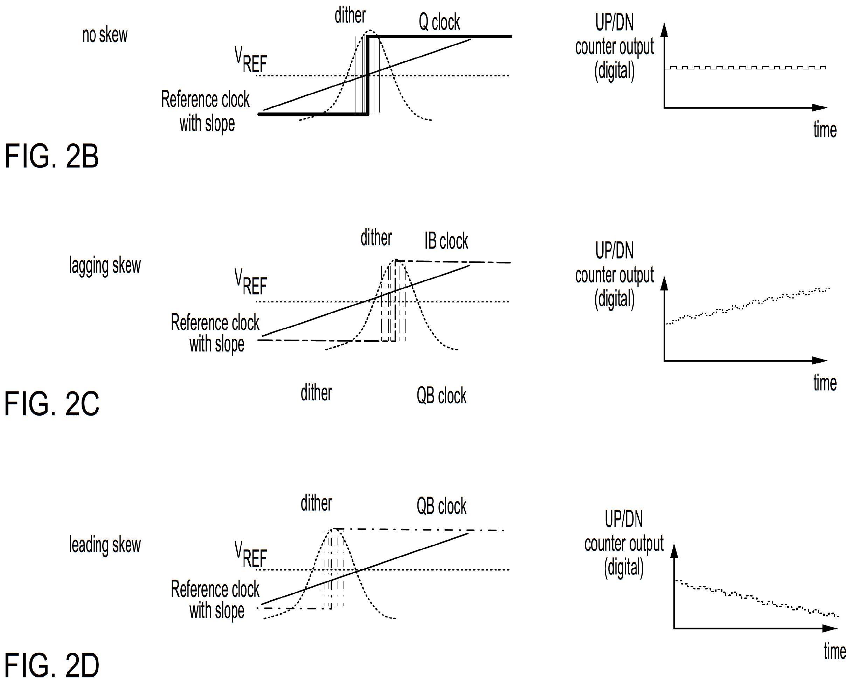

The reference signal is a signal having rising edges (or falling edges) with relatively low slope, e.g., during which the rate of change of the voltage is relatively low, as discussed in further detail below, in the context of FIGs. 2B - 2D. The reference signal may be generated from the received clock signal, in a manner described in further detail below. Some or all of the rising edges (or falling edges) of the reference clock signal coincide or nearly coincide with corresponding rising edges (or falling edges) of each clock signal of the four-phase composite clock signal. The reference signal may be generated by filtering a reduced frequency clock signal derived from the received clock with a low-pass filter (e.g., with a resistor-capacitor (RC) filter, as shown).

The output of each of the clocked comparators 230 is connected to a respective up-down counter 245, as shown. Each up-down counter 245 may accumulate a number of decisions of the clocked comparator 230 to which it is connected, thereby producing a more reliable indication of whether the mean phase of the clock signal of the four-phase composite clock signal leads or lags the reference signal 235, as discussed below. Each up-down counter 245 may operate as a digital low-pass filter, to smooth the output of the corresponding clocked comparator 230, so that the resulting signal is less affected by noise (including the pseudorandom noise added by the dither). In some embodiments, a different digital low-pass filter (e.g., a finite impulse response (FIR) filter) is used.

FIG. 2B shows a graph of the signals at the three inputs of a clocked comparator 230 in a circumstance in which the mean phase of the clock signal (of the four-phase composite clock signal) neither leads nor lags the reference signal. Each rising edge of the clock signal triggers a comparison between the reference signal 235 (which may be generated from a reference clock signal) and the reference voltage 240. Because of the dither, on some occasions the rising edge of the clock signal occurs before the point in time at which the reference signal 235 equals the reference voltage 240, and the output of the clocked comparator 230 is zero. On other occasions, the rising edge of the clock signal occurs after the point in time at which the reference signal 235 equals the reference voltage 240, and the output of the clocked comparator 230 is one. If the median phase of the dithered clock signal (over all possible dither values) is the phase for which the rising edge in the clock signal coincides with the point in time at which the reference signal 235 equals the reference voltage 240, then the output of the clocked comparator 230 will, on average, be one as often as it is zero. This may cause the output of the up-down counter (which may count up whenever the output of the clocked comparator 230 is one and which may count down whenever the output of the clocked comparator 230 is zero) to remain relatively constant.

FIG. 2C shows a graph of the signals at the three inputs of a clocked comparator 230 in a circumstance in which the median phase of the clock signal (of the four-phase composite clock signal) lags the reference signal. As is the case in the circumstance of FIG. 2B, each rising edge of the clock signal triggers a comparison between the reference signal 235 and the reference voltage. Because of the dither, on some occasions the rising edge of the clock signal occurs before the point in time at which the reference signal 235 equals the reference voltage 240, and the output of the clocked comparator 230 is zero. On other occasions, the rising edge of the clock signal occurs after the point in time at which the reference signal 235 equals the reference voltage 240, and the output of the clocked comparator 230 is one. If the median phase of the dithered clock signal (over all possible dither values) is a phase for which the rising edge in the clock signal lags (occurs after) the point in time at which the reference signal 235 equals the reference voltage 240, then the output of the clocked comparator 230 will, on average, be one more often than it is zero. This may cause the output of the up-down counter to increase over time, as shown in the graph on the right hand side of FIG. 2C.

FIG. 2D shows a graph of the signals at the three inputs of a clocked comparator 230 in a circumstance in which the median phase of the clock signal (of the four-phase composite clock signal) leads the reference signal. As is the case in the circumstance of FIG. 2B, each rising edge of the clock signal triggers a comparison between the reference signal 235 and the reference voltage. Because of the dither, on some occasions the rising edge of the clock signal occurs before the point in time at which the reference signal 235 equals the reference voltage 240, and the output of the clocked comparator 230 is zero. On other occasions, the rising edge of the clock signal occurs after the point in time at which the reference signal 235 equals the reference voltage 240, and the output of the clocked comparator 230 is one. If the median phase of the dithered clock signal (over all possible dither values) is a phase for which the rising edge in the clock signal leads (occurs before) the point in time at which the reference signal 235 equals the reference voltage 240, then the output of the clocked comparator 230 will, on average, be zero more often than it is one. This may cause the output of the up-down counter to decrease over time, as shown in the graph on the right hand side of FIG. 2D. As such, whether the output of the up-down counter 245 increases, decreases, or remains constant with time, and the rate at which it changes, if it changes, may indicate the direction and magnitude of the clock skew of the clock signal fed to the clocked comparator 230 which feeds the up-down counter 245.

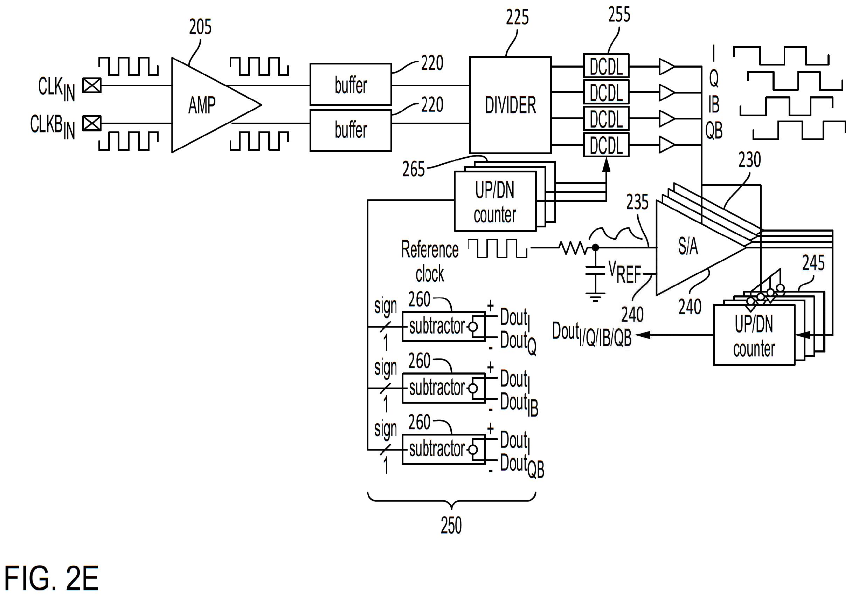

FIG. 2E shows the circuit of FIG. 2A, and also shows a feedback circuit 250 for correcting clock skew. The feedback circuit 250 may execute periodically; each time it executes, it may adjust one or more of a plurality of digitally controlled delay lines (DCDLs) 255 so as to reduce clock skew. For example, the digitally controlled delay line 255 of the in-phase clock signal may first be set based on the value of the up-down counter 245 of the in-phase clock signal; for example, this digitally controlled delay line 255 may be adjusted until the value of the up-down counter 245 of the in-phase clock signal is substantially constant.

The feedback circuit 250 may then calculate the relative skew between the in-phase clock signal and each of the other three clock signals of the four-phase composite clock signal, and adjust the digitally controlled delay lines 255 of the other three clock signals so as to reduce the relative skew. As used herein, the "relative skew" between a first clock signal and a second clock signal means the difference between the skew of the first clock signal and the skew of the second clock signal, each having been measured relative to the reference signal. For example, the relative skew between the in-phase clock signal and the quadrature clock signal may be calculated by subtracting the value of the up-down counter 245 of the quadrature clock signal (a value which may be proportional to the skew of the quadrature clock signal) from the value of the up-down counter 245 of the in-phase clock signal (a value which may be proportional to the skew of the in-phase clock signal).

The feedback circuit 250 may calculate, using one or more respective subtractors 260, one or more one-bit differences between the contents of respective up-down counters 245. Each one-bit difference produced by a subtractor 260 may be positive if the first operand is greater than the second operand and negative otherwise. For example, if the clock skew of the quadrature clock signal is negative relative to (e.g. less lagging than) the skew of the in-phase clock signal, then the content of the up-down counter 245 associated with the quadrature clock signal may be smaller than the content of the up-down counter 245 associated with the in-phase clock signal, and the output of the subtractor may be one. This may cause another up-down counter, which may be referred to herein as a feedback counter 265, to count up, and the increased count may be fed to the digitally controlled delay line 255 of the quadrature phase signal, to reduce the relative skew between the in-phase clock signal and the quadrature clock signal. Each of (i) the complement of the in-phase clock signal and (ii) the complement of the quadrature clock signal may also be compared to the in-phase clock signal, and the relative skew may be corrected in a similar manner, by the other two feedback counters 265 of the three feedback counters 265.

FIG. 3A depicts a clock input circuit 205, in some embodiments. The clock input circuit 205 includes (i) a differential amplifier 210 for amplifying the received clock signal (which may be attenuated by transmission through, e.g., the channel between the CPU 105 and the memory 110) and (ii) a phase dithering circuit 215, in some embodiments. The phase dithering circuit 215 includes a linear-feedback shift register 305, which generates a sequence of pseudorandom noise bits, of which a first subset are used to control respective switches of a bank of switches 320 to generate a phase offset for the clock signal 310 and a second subset are similarly used to generate a phase offset for the complement of the clock signal 315. Each switch may connect a first terminal of a respective capacitor of a bank of capacitors 325 to Vdd or to ground, so as to apply a delay offset to the clock signal to which the other terminal of the capacitor is connected. For example, phase dithering circuit 215 may provide an adjustable delay (resistor-capacitor (RC) delay) by closing some of the switches connected to the capacitors. To the extent the switches are open, the corresponding capacitors may be floating and, and such, may not provide delay if the switches are open (turned off).

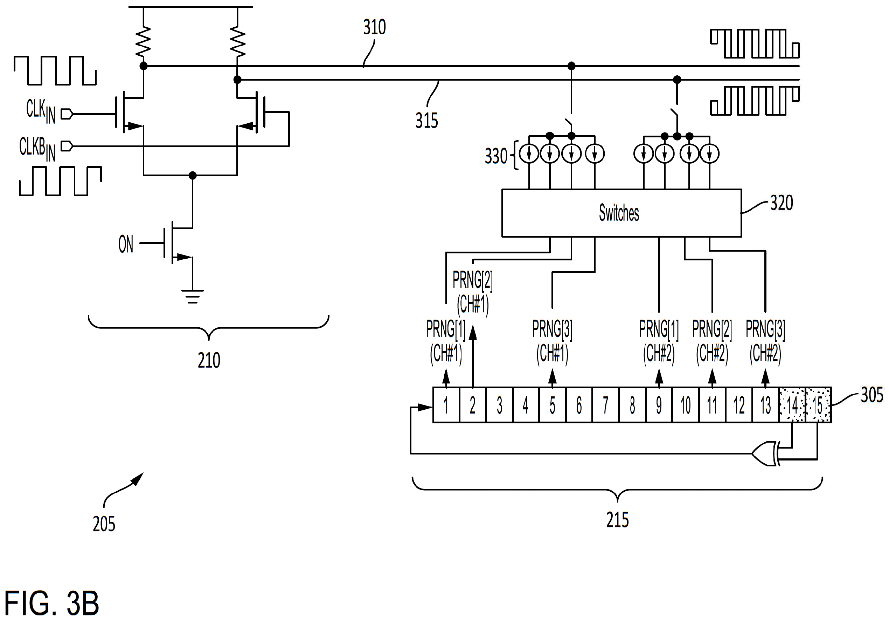

The capacitors may have values differing by powers of two as shown; this may result in a delay dither that is normally distributed. Other choices of capacitor values may be used to achieve different distributions. In the circuit of FIG. 3A, the pseudorandom word controlling the delay offset of the clock signal 310 is in general different from the pseudorandom word controlling the delay offset of the complement of the clock signal 315. In some embodiments the two delay offsets are arranged to be the same, by using only one subset of bits from the linear-feedback shift register 305, and using each bit to control two switches, one to apply a delay offset to the clock signal 310 and another to apply the same delay offset to the complement of the clock signal 315. FIG. 3B is an analogous circuit to that of FIG. 3A, with the coupling to the clock signal 310 and to the complement of the clock signal 315 being performed by current sources 330 (which may be metal oxide semiconductor field effect transistors (MOSFETs)) instead of by capacitors 325. In some embodiments, the delay is proportional to the weighted sum of the bits that control the switches, and the weights, which may be proportional to the sizes of the capacitors or the strengths of the current sources, may have different signs (e.g., some switches may be turned on when the corresponding bits are one, and some switches may be turned off when the corresponding bits are one). In some embodiments, the clock frequency of the pseudorandom signal generator is between the frequency of the received clock signal (e.g., CLK, FIG. 2A) and 0.001 times the frequency of the received clock signal.

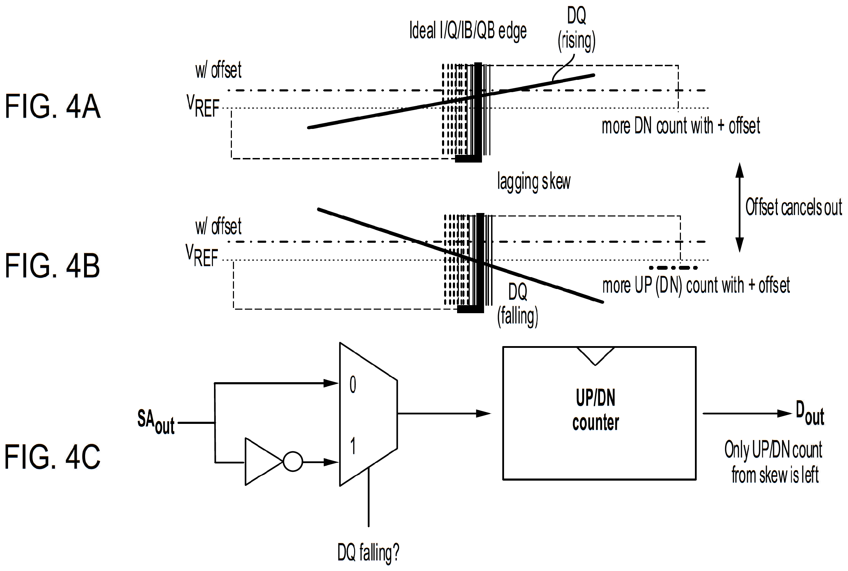

In the circuit of FIGs. 2A and 2E, an input offset in one of the clocked comparators 230 may result in an error in the skew estimate. As such, a modified circuit in which each clocked comparator 230 is triggered both on rising edges of the reference signal 235 and on falling edges of the reference signal 235 may be used, to cancel out the effect of the input offset. FIGs. 4A and 4B show the clock signal and reference signal waveforms at the points at which they cross. The output of the clocked comparator 230 may be inverted at each falling edge of the reference signal 235 using the circuit of FIG. 4C. As shown in FIGs. 4A and 4B, an offset (which may be equivalent to a change in the reference voltage 240) may have the effect, when the circuit of FIG. 4C is in use, of increasing the number of down counts at rising edges of the reference signal 235 and increasing the number of up counts at falling edges of the reference signal, so that the effect of the offset may be reduced.

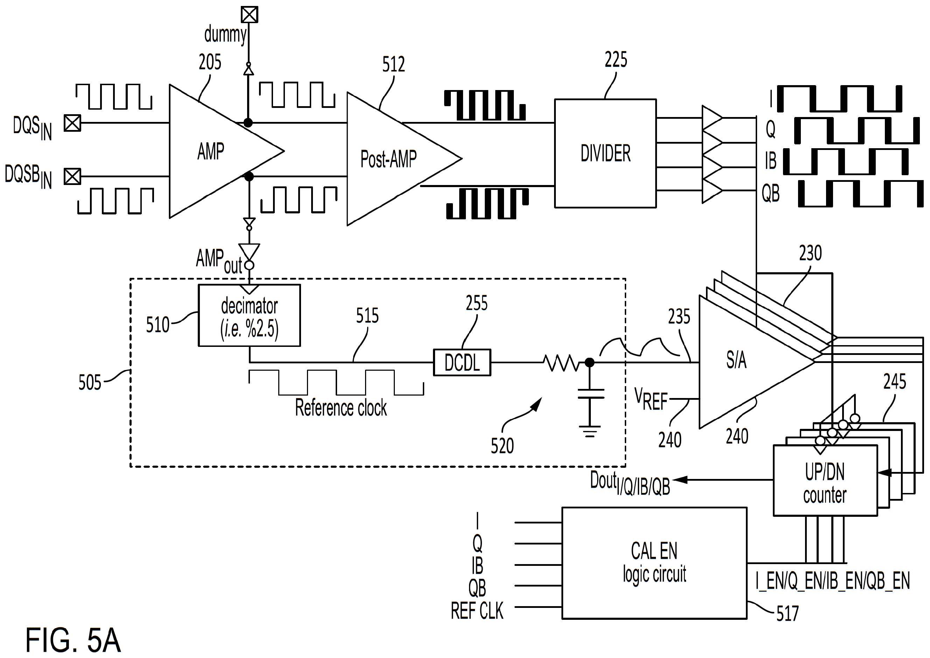

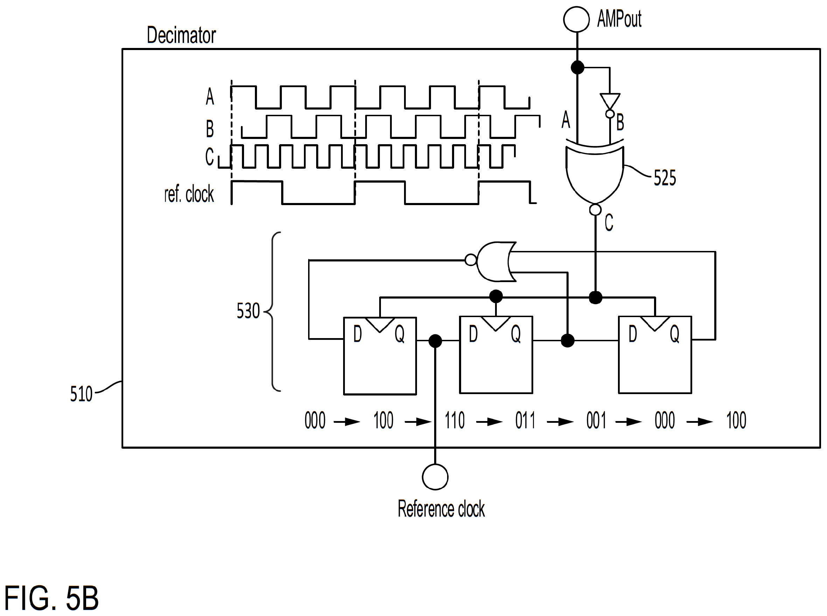

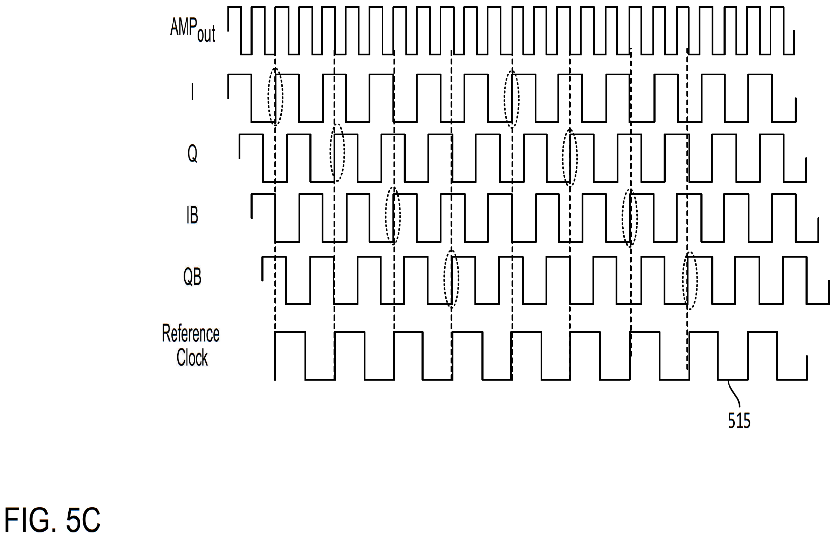

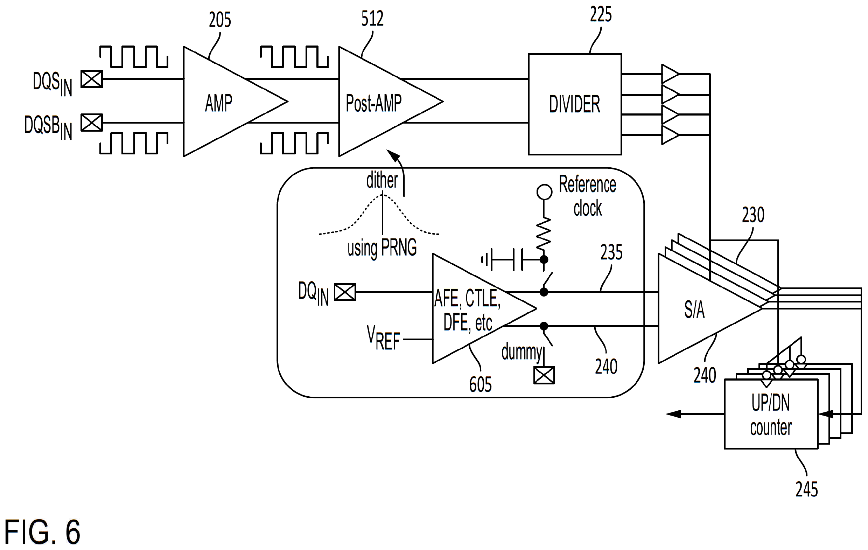

FIGs. 5A, 5B and 5C depict the structure and operation of a reference signal generator 505. A decimator (or "frequency-reducing circuit") 510 receives a copy of the received clock signal (before the application of the dither, which in the circuit of FIG. 5A is applied in the post amp 512). This copy may be referred to as the amp-out (or AMPₒᵤₜ) signal. The decimator 510 generates from the amp-out signal a rectangle-wave reference clock signal 515 having a frequency that is a non-integer fraction of the amp-out signal, e.g., the frequency of the amp-out signal may be 2.5 times the frequency of the rectangle-wave reference clock signal 515. The phase of the reference clock signal 515 may be adjusted using a digitally controlled delay line 255, and filtered with a low-pass filter 520, as shown, to generate the reference signal 235. In the embodiment of FIG. 5A and FIG. 6, (i) the phase dithering circuit 215 is part of the post amp 512, which may otherwise be similar to, or the same as, the pair of buffers 220 shown in FIGs. 2A and 2E, and (ii) the clock input circuit 205 lacks the phase dithering circuit 215 (the clock input circuit 205 of FIG. 5A and FIG. 6 may otherwise be the same as the clock input circuit 205 of FIGs. 2A and 2E).

FIG. 5B shows the structure of the decimator, in some embodiments. An XOR gate 525 generates, from the amp-out signal, a series of pulses at the output C of the XOR gate 525, including one pulse for each rising edge and one pulse for each falling edge of the amp-out signal. The series of pulses is connected to the clock input of three flip-flops configured as a three-bit shift register with NOR gate feedback 530, which cycles through a sequence of five 3-bit words as shown. The output of the first shift register is then a rectangle wave with a frequency that is one fifth of the frequency of the sequence of pulses at the output C (and, therefore, two-fifths of the frequency of the amp-out signal).

FIG. 5C shows waveforms of the amp-out signal, the four clock signals of the four-phase composite clock signal, and the reference clock signal 515. The reference clock signal 515 has one rising edge for every five edges (rising or falling) of the amp-out signal, which has twice the frequency of each of the four clock signals of the four-phase composite clock signal. Because of these frequency ratios, the reference clock may (for the phase illustrated) have a sequence of rising edges each aligned with an edge of a respective one of the four clock signals of the four-phase composite clock signal, as shown by the ellipses in FIG. 5C. The phase illustrated for the reference clock signal 515 is aligned with clock edges of the four clock signals of the four-phase composite clock signal for ease of illustration; the reference clock signal 515 used for skew calibration may have a phase that is advanced, e.g., by about one half cycle of the amp-out signal (relative to the phase illustrated), so that, after low-pass filtering, the rising edge of the reference signal 235 may be approximately centered, in time, on the rising edge of the clock signal to which it is being compared (e.g., in FIGs. 2B - 2D). A calibration enabling logic circuit 517 (e.g., a circuit including or consisting of logic gates) may be used, during skew calibration, to disable each of the up-down counters 245 except the one corresponding to clock signal, of the four-phase composite clock signal, being compared to the current edge of the reference signal 235. The calibration enabling logic circuit 517 may, for example, constructed using (i) an AND gate (e.g., to form I*REF CLK, or Q*REF CLK) with one or more delays or (ii) using a series of shift-register synchronized with the REF CLK (going from I_EN, Q_EN, IB_EN, QB_EN, and back to I_EN with REF_CLK, with one or more delays).

FIG. 6 shows the circuit of FIGs. 2A, 2E, and 5A in a second state, when the circuit is in operation receiving serial data. An analog circuit 605, which may be disconnected in the first state, and that includes, e.g., an analog front end (AFE), a continuous time linear equalizer (CTLE) and a decision feedback equalizer (DFE) may receive the serial data signal, process it, and send it to the clocked comparators 230. Most of the circuit elements used for clock skew calibration in the first state are used in the second state; as such, the error sources that may be present in the second state (e.g., timing variations caused by variations in the threshold voltage, in the parasitic capacitance, or in the doping of transistors in the circuits, or path mismatches), may be present in the first state, and therefore compensated for when clock skew calibration is performed.

In some embodiments, a system includes a first circuit, configured, in a first state, to apply a first adjustment (e.g., a phase dither) to a phase of a first clock signal to generate a phase-adjusted clock signal having an adjusted phase; and a second circuit, configured to compare the phase of the phase-adjusted clock signal to a phase of a reference signal. For example, as discussed above in the context of 2A - 2D, in some embodiments, in a first state (e.g., in a skew calibration state, which may be performed during manufacturing of the system, or at startup of the system, or periodically, when normal operation (in the second state) is temporarily halted to perform a clock skew calibration) the phase of a received clock signal may be dithered to generate a phase-adjusted clock signal(e.g., the in-phase clock signal, or any other clock signal of the four-phase composite clock signal, each of which is phase-adjusted (e.g., dithered) as a result of the dither applied by the phase dithering circuit 215). The phase of the phase-adjusted clock signal may then be compared to the phase of the reference signal 235, in the corresponding clocked comparator 230. In some embodiments, the first adjustment is a time-varying adjustment. For example, as discussed above in the context of FIGs 3A and 3B, the first adjustment (e.g., the dither) may be a time varying pseudorandom dither. In some embodiments, the first clock signal is derived from a received clock signal, and the reference signal is derived from the received clock signal. For example, both of the in-phase clock signal and the reference signal 235 may be derived from the received clock signal. As used herein, a signal is "derived from" a clock signal if the signal is generated using the clock signal as the only frequency reference, e.g., without influence from another frequency reference such as a crystal oscillator or voltage controlled oscillator.

In some embodiments, as discussed above in the context of FIGs. 3A and 3B, the first circuit includes a pseudo-random number generator, and the first circuit is configured to apply the first adjustment to the phase of the first clock signal based on an output of the pseudo-random number generator. In some embodiments, the first circuit is configured, in the first state, to adjust the phase by more than 1% of a period of the first clock signal and by less than 30% of the period of the first clock signal. In some embodiments, the second circuit is configured to compare, at an edge of the phase-adjusted clock signal, the reference signal to a reference voltage, and in some embodiments, the second circuit includes a clocked comparator clocked by the phase-adjusted clock signal. For example, as discussed above in the context of FIGs. 2B - 2D, each clocked comparator 230 may compare the reference signal 235 to the reference voltage 240 at a point in time at which the clock input of the clocked comparator 230 receives an edge (e.g., at a point in time at which the phase-adjusted clock signal has an edge).

In some embodiments, as illustrated for example in FIG. 2A, a first input of the clocked comparator is connected to the reference signal, and a second input of the clocked comparator is connected to a reference voltage. In some embodiments, the system further includes a circuit 505 (illustrated, for example, in FIGs. 5A and 5B) for generating the reference signal. In some embodiments, the reference signal has, at a point at which it equals the reference voltage, a slope less than 10 times a peak-to-peak amplitude of the reference signal divided by a period of the reference signal. For example, as illustrated in FIGs. 2B - 2D, the slope of the reference signal may be relatively small, as a result of the effect of the low-pass filter 520 (FIG. 5A). In some embodiments, the circuit for generating the reference signal includes a frequency-reducing circuit (e.g., the decimator 510, shown in FIG. 5) configured to generate, from a received clock signal, a reduced-frequency clock signal.

In some embodiments, the circuit for generating the reference signal further includes a low-pass filter, e.g., the RC filter 520 shown in FIG. 5A. In some embodiments, the system further includes a digital low-pass filter (such as an up-down counter 245), e.g., in some embodiments, the digital low-pass filter includes an up-down counter.

In some embodiments, the first circuit is configured, in a second state, to apply a second adjustment to the phase of the first clock signal, the second adjustment being a fixed adjustment. For example, in the second state (which may be an operating state, employed after dither calibration has been completed in the first state), one or more digitally controlled delay lines 255 may be used to apply fixed phase adjustments, the fixed phase adjustments to be used having been determined during the skew calibration operation in the first state. As such, in some embodiments, the system further includes a digitally controlled delay line configured to apply the second adjustment.

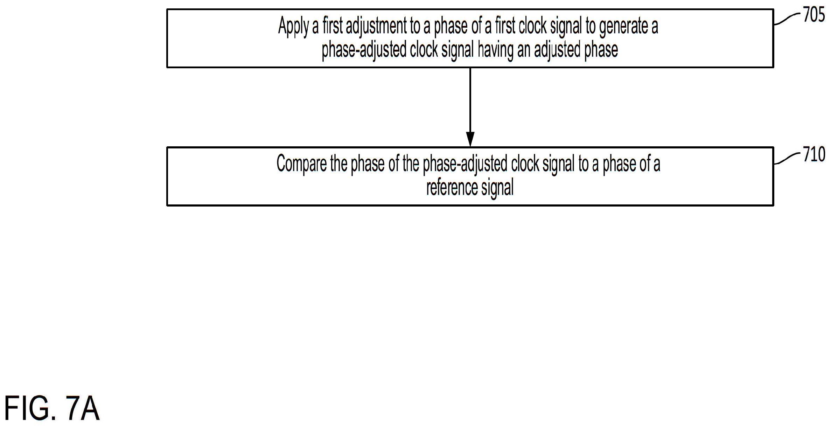

FIGs. 7A-7C show a method of clock skew calibration, in some embodiments. Although FIGs. 7A-7C illustrate various operations in such a method, embodiments according to the present disclosure are not limited thereto. For example, according to some embodiments, such a method may include additional operations or fewer operations, or the order of operations may vary (unless otherwise explicitly stated or implied) without departing from the spirit and scope of embodiments according to the present disclosure.

The method may include applying, at 705, a first adjustment to a phase of a first clock signal to generate a phase-adjusted clock signal having an adjusted phase; and comparing, at 710, the phase of the phase-adjusted clock signal to a phase of a reference signal. For example, as discussed above in the context of 2A - 2D, in some embodiments, in a first state (e.g., in a skew calibration state, which may be performed during manufacturing of the system, or at startup of the system, or periodically, when normal operation (in the second state) is temporarily halted to perform a clock skew calibration) the applying, at 705, of the first adjustment to a phase of a first clock signal may involve dithering the phase of a received clock signal to generate a phase-adjusted clock signal (e.g., the in-phase clock signal, or any other clock signal of the four-phase composite clock signal, each of which is phase-adjusted (e.g., dithered) as a result of the dither applied by the phase dithering circuit 215). The comparing, at 710, of the phase of the phase-adjusted clock signal to the phase of the reference signal may include comparing the phase of the phase-adjusted clock signal to the phase of the reference signal 235 in the corresponding clocked comparator 230. As used herein, the "phase of the reference signal" refers to the points in time at which the reference signal 235 is equal to the reference voltage 240; e.g., the phase of the reference signal may be considered to be the phase of a hypothetical square wave or rectangle wave having edges at the points in time at which the reference signal 235 is equal to the reference voltage 240.

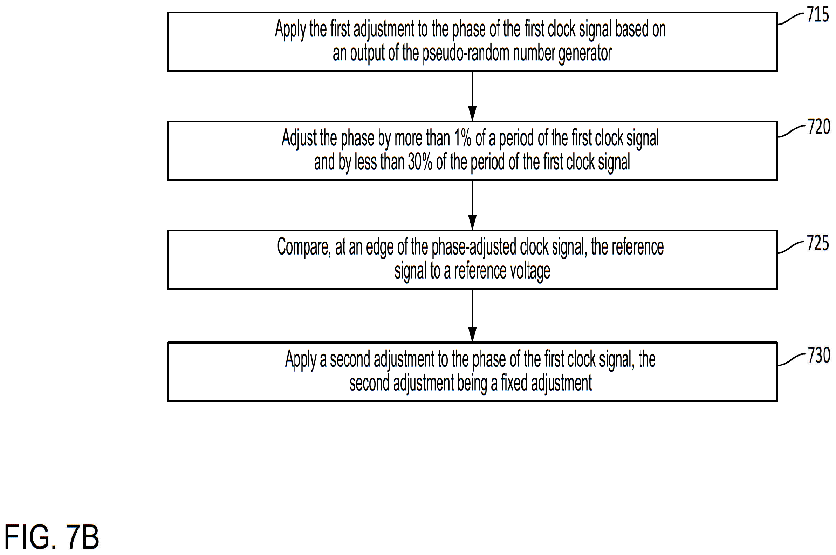

FIG. 7B shows further aspects of a method of clock skew calibration, in some embodiments. Although FIG. 7B illustrates various operations in such a method, embodiments according to the present disclosure are not limited thereto. For example, according to some embodiments, such a method may include additional operations or fewer operations, or the order of operations may vary (unless otherwise explicitly stated or implied) without departing from the spirit and scope of embodiments according to the present disclosure.

The method of FIG. 7B may include applying, at 715, the first adjustment to the phase of the first clock signal based on an output of the pseudo-random number generator. The method may further include adjusting, at 720, the phase by more than 1% of a period of the first clock signal and by less than 30% of the period of the first clock signal. The method may further include comparing, at 725, at an edge of the phase-adjusted clock signal, the reference signal to a reference voltage. The method may further include applying, at 730, a second adjustment to the phase of the first clock signal, the second adjustment being a fixed adjustment.

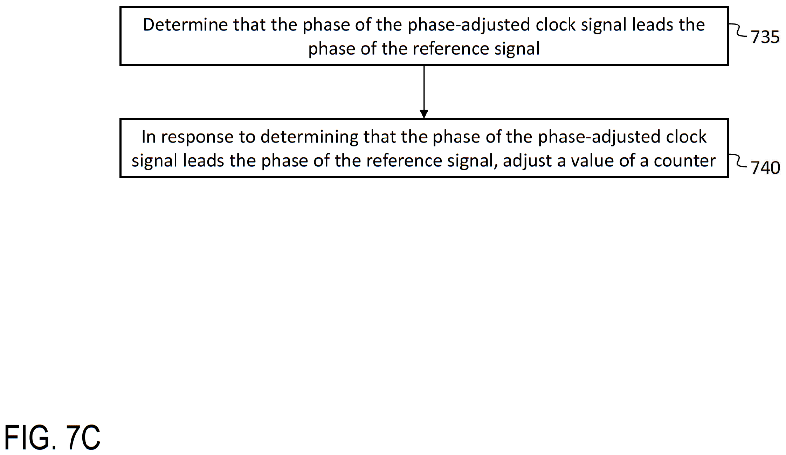

The method of FIG. 7C includes operations that may be performed with (e.g., after) the operations of FIG. 7A. The method of FIG. 7C may include determining, at 735, that the phase of the phase-adjusted clock signal leads the phase of the reference signal; and, at 740, in response to determining that the phase of the phase-adjusted clock signal leads the phase of the reference signal, adjusting a value of a counter. For example, as discussed above in the context of FIGs. 2B - 2D, if the rising edge of the clock signal occurs before the point in time at which the reference signal 235 equals the reference voltage 240, the up-down counter 245 may count down.

As used herein, "a portion of" something means "at least some of" the thing, and as such may mean less than all of, or all of, the thing. As such, "a portion of" a thing includes the entire thing as a special case, i.e., the entire thing is an example of a portion of the thing. As used herein, when a second quantity is "within Y" of a first quantity X, it means that the second quantity is at least X-Y and the second quantity is at most X+Y. As used herein, when a second number is "within Y%" of a first number, it means that the second number is at least (1-Y/100) times the first number and the second number is at most (1+Y/100) times the first number. As used herein, the term "or" should be interpreted as "and/or", such that, for example, "A or B" means any one of "A" or "B" or "A and B".

Each of the terms "processing circuit" and "means for processing" is used herein to mean any combination of hardware, firmware, and software, employed to process data or digital signals. Processing circuit hardware may include, for example, application specific integrated circuits (ASICs), general purpose or special purpose central processing units (CPUs), digital signal processors (DSPs), graphics processing units (GPUs), and programmable logic devices such as field programmable gate arrays (FPGAs). In a processing circuit, as used herein, each function is performed either by hardware configured, i.e., hard-wired, to perform that function, or by more general-purpose hardware, such as a CPU, configured to execute instructions stored in a non-transitory storage medium. A processing circuit may be fabricated on a single printed circuit board (PCB) or distributed over several interconnected PCBs. A processing circuit may contain other processing circuits; for example, a processing circuit may include two processing circuits, an FPGA and a CPU, interconnected on a PCB. As used herein, a "circuit' is a set of conductors and elements (e.g., resistors, capacitors, inductors, transistors, and the like) connected together and configured to perform an electrical function.

As used herein, when a method (e.g., an adjustment) or a first quantity (e.g., a first variable) is referred to as being "based on" a second quantity (e.g., a second variable) it means that the second quantity is an input to the method or influences the first quantity, e.g., the second quantity may be an input (e.g., the only input, or one of several inputs) to a function that calculates the first quantity, or the first quantity may be equal to the second quantity, or the first quantity may be the same as (e.g., stored at the same location or locations in memory as) the second quantity.

It will be understood that, although the terms "first", "second", "third", etc., may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed herein could be termed a second element, component, region, layer or section, without departing from the spirit and scope of the inventive concept.

Spatially relative terms, such as "beneath", "below", "lower", "under", "above", "upper" and the like, may be used herein for ease of description to describe one element or feature's relationship to another element(s) or feature(s) as illustrated in the figures. It will be understood that such spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. In addition, it will also be understood that when a layer is referred to as being "between" two layers, it can be the only layer between the two layers, or one or more intervening layers may also be present.

The terminology used herein is for the purpose of describing particular embodiments only and is not intended to be limiting of the inventive concept. As used herein, the terms "substantially," "about," and similar terms are used as terms of approximation and not as terms of degree, and are intended to account for the inherent deviations in measured or calculated values that would be recognized by those of ordinary skill in the art.

It will be further understood that the terms "comprises" and/or "comprising", when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list. Further, the use of "may" when describing embodiments of the inventive concept refers to "one or more embodiments of the present disclosure". Also, the term "exemplary" is intended to refer to an example or illustration. As used herein, the terms "use," "using," and "used" may be considered synonymous with the terms "utilize," "utilizing," and "utilized," respectively.

It will be understood that when an element or layer is referred to as being "on", "connected to", "coupled to", or "adjacent to" another element or layer, it may be directly on, connected to, coupled to, or adjacent to the other element or layer, or one or more intervening elements or layers may be present. In contrast, when an element or layer is referred to as being "directly on", "directly connected to", "directly coupled to", or "immediately adjacent to" another element or layer, there are no intervening elements or layers present.

Any numerical range recited herein is intended to include all sub-ranges of the same numerical precision subsumed within the recited range. For example, a range of "1.0 to 10.0" or "between 1.0 and 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Similarly, a range described as "within 35% of 10" is intended to include all subranges between (and including) the recited minimum value of 6.5 (i.e., (1 - 35/100) times 10) and the recited maximum value of 13.5 (i.e., (1 + 35/100) times 10), that is, having a minimum value equal to or greater than 6.5 and a maximum value equal to or less than 13.5, such as, for example, 7.4 to 10.6. Any maximum numerical limitation recited herein is intended to include all lower numerical limitations subsumed therein and any minimum numerical limitation recited in this specification is intended to include all higher numerical limitations subsumed therein.

It will be understood that when an element is referred to as being "directly connected" or "directly coupled" to another element, there are no intervening elements present. As used herein, "generally connected" means connected by an electrical path that may contain arbitrary intervening elements, including intervening elements the presence of which qualitatively changes the behavior of the circuit. As used herein, "connected" means (i) "directly connected" or (ii) connected with intervening elements, the intervening elements being ones (e.g., low-value resistors or inductors, or short sections of transmission line) that do not qualitatively affect the behavior of the circuit.

Although exemplary embodiments of a system and method for skew calibration have been specifically described and illustrated herein, many modifications and variations will be apparent to those skilled in the art. Accordingly, it is to be understood that a system and method for skew calibration constructed according to principles of this disclosure may be embodied other than as specifically described herein. The invention is also defined in the following claims.

## Claims

1. A system, comprising:
a first circuit, configured, in a first state, to apply a first adjustment to a phase of a first clock signal to generate a phase-adjusted clock signal having an adjusted phase; and
a second circuit, configured to compare the phase of the phase-adjusted clock signal to a phase of a reference signal.

2. The system of claim 1, wherein the first adjustment is a time-varying adjustment.

3. The system of claim 1 or 2, wherein:
the first clock signal is derived from a received clock signal, and
the reference signal is derived from the received clock signal.

4. The system of any one of claims 1 to 3, wherein the first circuit comprises a pseudo-random number generator, and the first circuit is configured to apply the first adjustment to the phase of the first clock signal based on an output of the pseudo-random number generator.

5. The system of any one of claims 1 to 4, wherein the first circuit is configured, in the first state, to adjust the phase by more than 1% of a period of the first clock signal and by less than 30% of the period of the first clock signal.

6. The system of any one of claims 1 to 5, wherein:
the second circuit is configured to compare, at an edge of the phase-adjusted clock signal, the reference signal to a reference voltage.

7. The system of claim 6, wherein the second circuit comprises a clocked comparator clocked by the phase-adjusted clock signal.

8. The system of claim 7, wherein a first input of the clocked comparator is connected to the reference signal, and a second input of the clocked comparator is connected to the reference voltage.

9. The system of claim 7 or 8, further comprising a digital low-pass filter, connected to an output of the clocked comparator.

10. The system of claim 9, wherein the digital low-pass filter comprises an up-down counter.

11. The system of any one of claims 1 to 10, further comprising a circuit for generating the reference signal.

12. The system of claim 11, wherein the reference signal has, at a point at which it equals a reference voltage, a slope less than 10 times a peak-to-peak amplitude of the reference signal divided by a period of the reference signal.

13. The system of claim 11 or 12, wherein the circuit for generating the reference signal comprises a frequency-reducing circuit configured to generate, from a received clock signal, a reduced-frequency clock signal.

14. The system of claim 13, wherein the circuit for generating the reference signal further comprises a low-pass filter.

15. The system of any one of claims 1 to 14, wherein the first circuit is configured, in a second state, to apply a second adjustment to the phase of the first clock signal, the second adjustment being a fixed adjustment.
